# EUROPEAN PATENT SPECIFICATION

(11) **EP 3 828 928 B1**
(45) Date of publication and mention of the grant of the patent: **07.06.2023**
(21) Application number: 20216817.5
(22) Date of filing: 19.01.2018
(51) Int. Cl.: H01L 25/065, H01L 23/538, H01L 23/00, H01L 25/18, H01L 23/498, H01L 23/50

(54) **EMBEDDED MULTI-DIE INTERCONNECT BRIDGE WITH IMPROVED POWER DELIVERY**
EINGEBETTETE MULTICHIP-VERBINDUNGSBRÜCKE MIT VERBESSERTER LEISTUNGSABGABE
PONT D'INTERCONNEXION MULTIMATRICE INTÉGRÉ AYANT UNE DISTRIBUTION D'ÉNERGIE AMÉLIORÉE

(30) Priority: 22.02.2017 US 201715439118
(43) Date of publication of application: 02.06.2021
(62) Divisional of application: 18152659.1
(73) Proprietor: INTEL Corporation, Santa Clara, CA 95054 (US)
(72) Inventor: LIU, Hui, Santa Clara, CA California 95054 (US); OH, Kyung Suk, Santa Clara, CA California 95054 (US)
(74) Representative: Goddar, Heinz J.

(56) References cited:
- JP-A- 2001 168 531
- US-A1- 2001 052 647
- US-A1- 2015 279 817
- US-A1- 2016 056 102
- US-B1- 9 129 935
- US-B1- 9 368 450

## Description

### Background

This relates generally to integrated circuit packages, and more particularly, to integrated circuit packages with embedded multi-die interconnect bridges (EMIBs) that connect more than one integrated circuit die.

An integrated circuit package typically includes an integrated circuit die and a substrate on which the die is mounted. The die can be coupled to the substrate through bonding wires or solder bumps. Signals from the integrated circuit die may then travel through the bonding wires or solder bumps to the substrate.

As demands on integrated circuit technology continue to outstrip even the gains afforded by ever decreasing device dimensions, more and more applications demand a packaged solution with more integration than possible in one silicon die. In an effort to meet this need, more than one die may be placed within a single integrated circuit package (i.e., a multichip package). As different types of devices cater to different types of applications, more dies may be required in some systems to meet the requirements of high performance applications. Accordingly, to obtain better performance and higher density, an integrated circuit package may include multiple dies arranged laterally along the same plane.

EMIBs are small silicon dies that are sometimes embedded in the substrate of a multichip package and are used to interconnect integrated circuit dies within that multichip package. Traditionally, these EMIBS have limited power delivery capability compared to other interposer technologies such as silicon interposers.

It is within this context that the embodiments described herein arise.

US 2016/056102 A1 discloses the use of a silicon bridge embedded in a package substrate, the package substrate being made of multiple layers. Some vias and traces in the multiple layers of the package substrate enable direct connection between the die and the printed circuit board. Micro bumps are used to connect the dies to the upper layer of the package substrate.

US 9 368 450 B1 describes an integrated device package which includes a first die, a second die, an encapsulation portion coupled to the first die and the second die, and a redistribution portion coupled to the encapsulation portion. The encapsulation portion includes an encapsulation layer, a bridge, and a first via. The bridge is at least partially embedded in the encapsulation layer. The bridge is configured to provide a first electrical path for a first signal between the first die and the second die. The first via is in the encapsulation layer. The first via is coupled to the bridge. The first via and the bridge are configured to provide a second electrical path for a second signal to the first die. The redistribution portion includes at least one dielectric layer, and at least one interconnect, in the dielectric layer, coupled to the first via.

US 2015/279817 A1 describes an apparatus including a package substrate including a plurality of layers 0f conductive material, the package substrate including a cavity; and a device in the cavity, wherein an ultimate layer of the plurality of layers of conductive material defines contacts to contact points of the device. An apparatus including a package substrate comprising a plurality of conductive layers and a silicon bridge die disposed between ones Of the plurality of conductive layers and an ultimate layer of the plurality of conductive layers defines contact points to contact points of the silicon bridge die; and a logic die coupled to the contact points of the ultimate layer of the plurality of layers of conductive layers.

US 2001/052647 A1 describes a low-cost integrated circuit package for packaging integrated circuits. The package comprises a flexible circuit that is laminated to a stiffener using a dielectric adhesive, with the conductive traces on the flexible circuit facing toward the stiffener but separated therefrom by the adhesive. The conductive traces include an array of flip-chip attachment pads. A window is formed in the stiffener over the attachment pad array, such as by etching. The adhesive is then removed over the attachment pads by laser ablation, but left in place between the pads, thus forming a flip-chip attachment site. JP 2001 168531 A describes a multilayer printed wiring board. A large-diameter through hole at an outer peripheral part is a signal line. A small-diameter through hole at a central part is a power source line and ground line, thus arraying multiple power source lines and ground lines and shortening the wiring length from an IC chip to a daughter board. So the inductance component of the power source line and ground line to the IC chip is reduced, preventing malfunction of the IC chip.

US 9 129 935 B1 describes a multi-chip package that includes multiple integrated circuits. An integrated circuit in the multi-chip package may be mounted on an interposer. The interposer may be mounted on a package substrate. The integrated circuit may have internal power supply terminals coupled to on-package decoupling (OPD) capacitor circuitry that are formed as part of the package substrate. The power supply terminals on the integrated circuit may be coupled to conductive routing paths and through-silicon vias (TSVs) in the interposer via microbumps. The through-silicon vias in the interposer may be coupled to the OPD capacitor circuitry via flip-chip bumps. The conductive routing paths and the TSVs in the interposer may be coupled to the internal integrated circuit power supply terminals in a way that minimizes power supply resonance noise.

The invention is defined in the independent claims. Embodiments of the invention are described in the dependent claims.

### Summary

Independent claim 1 defines a multi chip package according to the invention. Independent claim 9 defines a corresponding system according to the invention. Preferred embodiments are defined in the dependent claims.

An integrated circuit package may include a package substrate and one or more integrated circuit dies mounted on the package substrate. The package substrate may include an embedded multi-die interconnect bridge (EMIB) embedded within the package substrate. An EMIB is a silicon die that may be used to interconnect two integrated circuits in a multi-chip package. The integrated circuit dies mounted on the package substrate may communicate with one another through the EMIB. The EMIB may have a front side that faces the integrated circuit dies and a back side that opposes the front side. The package substrate may include a conductive path that is electrically coupled to the EMIB from the back side of the EMIB and that supplies power to the EMIB. The package substrate may be mounted on a printed circuit board that provides power to the EMIB through the conductive path.

The package substrate may also include a conductive layer (e.g., back side conductor) on which the EMIB is mounted. The conductive path may be connected to the conductive layer and may provide power to the EMIB through the conductive layer. A patterned adhesive layer may be applied to the conductive layer before the EMIB is mounted on the conductive layer and may include openings that accommodate conductive pads (e.g., contact pads) formed at the back side of the EMIB. In other words, once the EMIB is mounted on the conductive layer, the patterned adhesive layer may laterally surround the conductive pads formed at the back side of the EMIB. Additional contact pads may be formed at the front side of the EMIB.

The package substrate may include a first via directly connected to a contact pad formed at the front side of the EMIB, and may include a second via that is coupled to a contact pad formed at the back side of the EMIB through the conductive layer. The second via may have a diameter that is greater than a diameter of the first via.

The EMIB may include a conductive routing trace (e.g., interconnect) that is coupled to the integrated circuit dies. A microvia formed in the EMIB may be coupled between one of the conductive pads formed at the back side of the EMIB and the conductive routing trace. Power supply voltage signals or data signals may be provided to the conductive routing trace through the microvia.

The EMIB may include multiple through-silicon vias that extend from the back side of the EMIB to the front side of the EMIB. These through-silicon vias may be used to transfer power or data signals from the conductive path to the integrated circuit dies through the EMIB.

The conductive layer may include multiple conductive regions that are electrically isolated from one another. Each region of the conductive layer may receive a different power supply voltage signal or data signal from each other region of the conducive layer.

Fabricating an integrated circuit package may include multiple processing steps. A first dielectric layer may be formed. A via may be formed through the first dielectric layer. A conductive layer may be formed on the first dielectric layer in direct physical contact with the via. Forming the conductive layer may involve forming multiple conductive regions that are electrically isolated from one another. A silicon die (e.g., an EMIB) may be mounted on the conductive layer. Additional dielectric layers may be formed covering the silicon die. A first integrated circuit die may be mounted on the additional dielectric layers. A second integrated circuit die may be mounted on the additional dielectric layers. The silicon die may include a conductive routing trace that couples the first integrated circuit die to the second integrated circuit die.

Before forming the additional dielectric layer, a second dielectric layer may be formed on the first dielectric layer. A cavity may be formed in the second dielectric layer directly over the conductive layer. Mounting the silicon die on the conductive layer may include inserting the silicon die into the cavity. A patterned adhesive layer may be formed between the silicon die and the conductive layer. The patterned adhesive die may include a plurality of openings to accommodate contact pads formed on a bottom surface of the silicon die.

Further features of the present invention, its nature and various advantages will be more apparent from the accompanying drawings and the following detailed description.

### Brief Description of the Drawings

FIG. 1 is a diagram of an illustrative system of integrated circuit devices operable to communicate with one another in accordance with an embodiment.
FIG. 2 is a diagram of an illustrative multichip package in accordance with an embodiment.
FIG. 3 is a cross-sectional side view of an illustrative multichip package that includes two die coupled together using an embedded multi-die interconnect bridge (EMIB) in accordance with an embodiment.
FIG. 4 is a top view of an illustrative multichip package that includes two die coupled together using an EMIB in accordance with an embodiment.
FIG. 5 is a cross-sectional side view of an illustrative multichip package that includes an EMIB having through-silicon vias in accordance with an embodiment.
FIG. 6 is a cross-sectional side view of an illustrative EMIB having internal microvias in accordance with an embodiment.
FIG. 7A is a top view of an illustrative back side conductor for an EMIB that is horizontally separated into three voltage regions that are electrically isolated from one another in accordance with an embodiment.
FIG. 7B is a top view of an illustrative conductive back side conductor for an EMIB that is vertically separated into three voltage regions in accordance with an embodiment.
FIG. 7C is a top view of an illustrative conductive back side conductor that is separated into three voltage regions and two signal regions, which are all electrically isolated from each other in accordance with an embodiment.
FIG. 8 is a flow chart showing illustrative steps for forming a package substrate that includes an EMIB with improved power delivery capabilities in accordance with an embodiment.

### Detailed Description

Embodiments of the present invention relate to integrated circuits, and more particularly, to ways of improving power delivery through an embedded multi-die interconnect bridge in a multichip package.

As integrated circuit fabrication technology scales towards smaller process nodes, it becomes increasingly challenging to design an entire system on a single integrated circuit die (sometimes referred to as a system-on-chip). Designing analog and digital circuitry to support desired performance levels while minimizing leakage and power consumption can be extremely time consuming and costly.

One alternative to single-die packages is an arrangement in which multiple dies are placed within a single package. Such types of packages that contain multiple interconnected dies may sometimes be referred to as systems-in-package (SiPs), multi-chip modules (MCM), or multichip packages. Placing multiple chips (dies) into a single package may allow each die to be implemented using the most appropriate technology process (e.g., a memory chip may be implemented using the 28 nm technology node, whereas the radio-frequency analog chip may be implemented using the 45 nm technology node), may increase the performance of die-to-die interface (e.g., driving signals from one die to another within a single package is substantially easier than driving signals from one package to another, thereby reducing power consumption of associated input-output buffers), may free up input-output pins (e.g., input-output pins associated with die-to-die connections are much smaller than pins associated with package-to-board connections), and may help simplify printed circuit board (PCB) design (i.e., the design of the PCB on which the multi-chip package is mounted during normal system operation).

In order to facilitate communications between two chips on a multi-chip package, the package may include an embedded multi-die interconnect bridge (EMIB) that is designed and patented by INTEL Corporation. An EMIB is a small silicon die that is embedded in the underlying substrate of a multi-chip package and that offers dedicated ultra-high-density interconnection between dies within the package. EMIBs generally include wires of minimal length, which help to significantly reduce loading and directly boost performance.

EMIB solutions may be advantageous over other multi-chip packaging schemes that use a silicon interposer, which is prone to issues such as warpage and requires a comparatively large number of microbumps and through-silicon vias (TSVs) to be formed on and within the interposer, thereby reducing overall yield and increasing manufacturing complexity and cost. The number of dies that can be integrated using an interposer is also limited to that supported by EMIB technology.

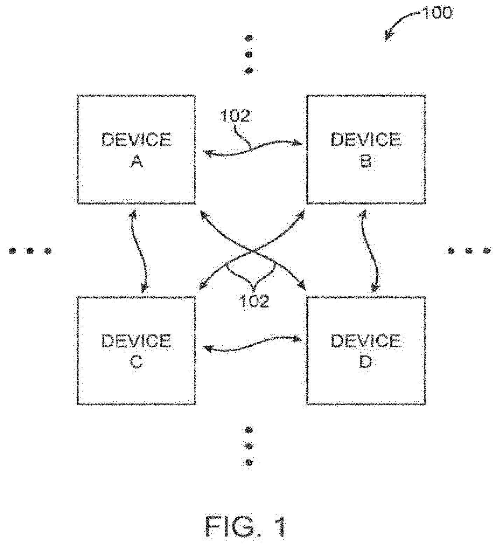

The EMIB technology described above may be used as an interface between one or more integrated circuit dies in a system. FIG. 1 is a diagram of an illustrative system 100 of interconnected electronic devices. The system of interconnected electronic devices may have multiple electronic devices such as device A, device B, device C, device D, and interconnection resources 102. Interconnection resources 102 such as conductive lines and busses, optical interconnect infrastructure, or wired and wireless networks with optional intermediate switching circuitry may be used to send signals from one electronic device to another electronic device or to broadcast information from one electronic device to multiple other electronic devices. For example, a transmitter in device B may transmit data signals to a receiver in device C. Similarly, device C may use a transmitter to transmit data to a receiver in device B.

The electronic devices may be any suitable type of electronic device that communicates with other electronic devices. Examples of such electronic devices include basic electronic components and circuits such as analog circuits, digital circuits, mixed-signal circuits, circuits formed within a single package, circuits housed within different packages, circuits that are interconnected on a printed-circuit board (PCB), etc.

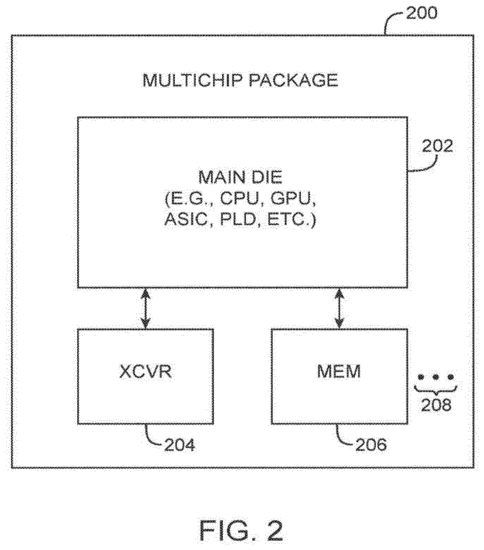

As shown in FIG. 2, a multi-chip package 200 may include a main die 202, a transceiver die 204, a memory die 206, and additional auxiliary dies 208. Main die 202, for example, may be a central processing unit (CPU), a graphics processing unit (GPU), an application-specific integrated circuit (ASIC), a programmable logic device (PLD), or any other desired processor or logic device. Secondary integrated circuit dies such as transceiver die 204, memory die 206, and auxiliary dies 208 may be coupled to main die 202 and may communicate with main die 202. Memory die 206, for example, may be an erasable-programmable read-only memory (EPROM) chip, a non-volatile memory (e.g., 3D XPoint) chip, a volatile memory (e.g., high bandwidth memory) chip, or any other suitable memory device. Auxiliary dies 208 may include additional memory dies, transceiver dies, programmable logic devices, and any other suitable integrated circuit devices.

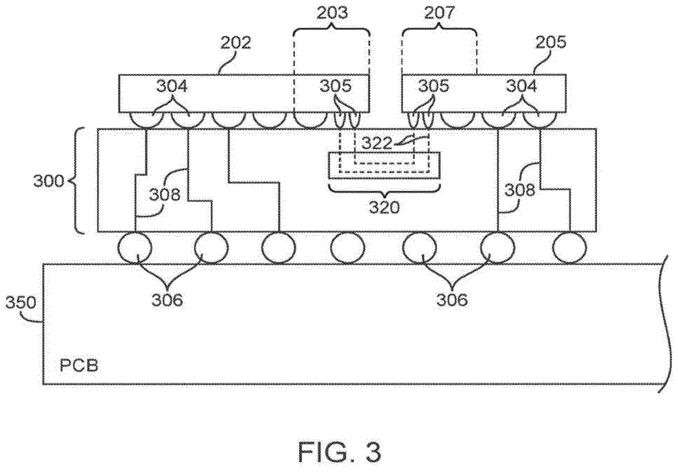

An EMIB may be embedded in a multi-chip package to connect two adjacent integrated circuit dies on the package. As shown in FIG. 3, main die 202 and secondary die 205 may be mounted onto package substrate 300 using solder bumps 304 and solder microbumps 305. Package substrate 300 may be mounted onto printed circuit board (PCB) 350 using solder (e.g., solder balls, solder bumps) 306. The terms solder "balls" or solder "bumps" may sometimes be use interchangeably. Signals (e.g., data signals and power supply voltage signals) may be transferred between PCB 350 and dies 202 and 205 through solder balls 306, package vias 308 in package 300, and solder bumps 304.

Main die 202 may be coupled to a secondary die 205 using EMIB 320 that is embedded in package substrate 300. Signals being passed between main die 202 and secondary die 205 may pass through interconnects (e.g., conductive paths) 322 and microbumps 305. EMIB 320 may have a front side that faces main die 202 and secondary die 205 and may have a back side that faces package substrate 300. An EMIB is traditionally formed on a solid, electrically floating conductive plate for structural support. It is therefore difficult to provide power to microbumps 305 that overlap with regions 203 and 207 of main die 202 and secondary die 205, as power cannot be delivered vertically from the PCB through the EMIB to regions 203 and 207 because back side routing is blocked by the conductive plate.

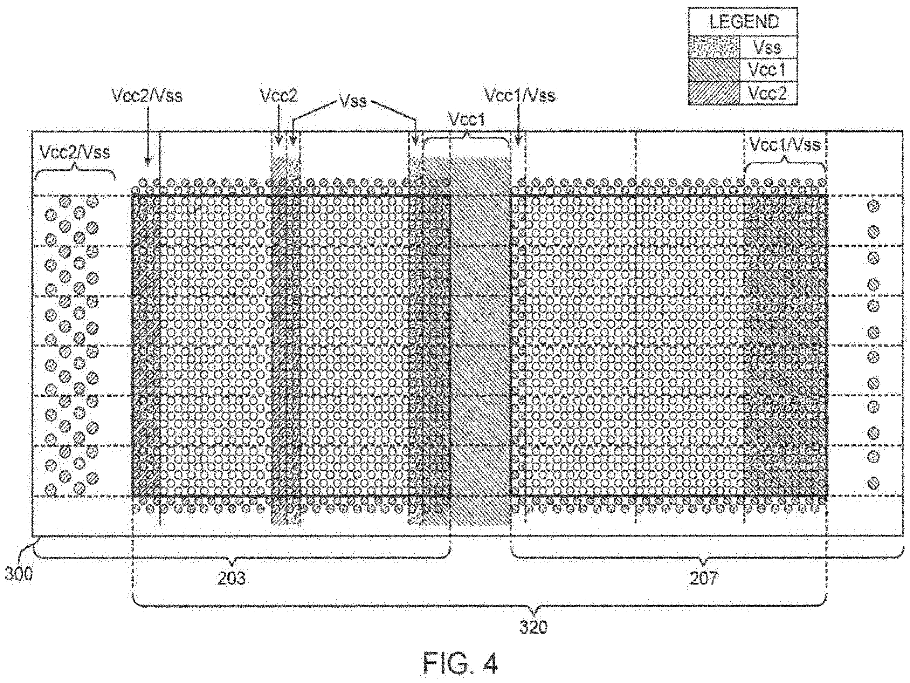

FIG. 4 shows a top view of package substrate 300 in regions 203 and 207 and illustrates possible means of power and ground signal delivery to microbump arrays in regions 203 and 207. Two microbump arrays in regions 203 and 207 may overlap with EMIB 320 formed in package substrate 300. Each microbump array, for example, may correspond to an edge of an integrated circuit die (e.g., main die 202 and secondary die 205 of FIG. 3). Three different voltage signals may be applied to the pads of package substrate 300: (1) a common voltage signal Vss (e.g., ground power supply voltage signal), (2) a power supply voltage signal Vcc1 for region 207 (e.g., for secondary die 205 in FIG. 3), and a power supply voltage signal Vcc2 for region 203 (e.g., for main die 202 of FIG. 3). It should be noted that a portion of the microbumps in region 203 may also receive power supply voltage signal Vcc1.

These power supply and common voltage signals may be delivered to peripheral microbumps in regions 203 and 207 without exceptional loss in power efficiency. For example, voltage signals Vss, Vcc1, and Vcc2 may be delivered to the microbumps at the edges of the microbump arrays of regions 203 and 207 using conductors (e.g., copper traces) formed in a top layer of the package substrate.

Additionally, microbumps in the center (e.g., not at the periphery) of the microbump arrays of regions 203 and 207 may have voltage signals Vss, Vcc1, and Vcc2 routed to them by forming conductors (e.g., copper traces) in a top layer of the package substrate arranged to extend vertically across a given microbump array. Only microbumps in the path of one of these conductors may receive the respective voltage signal carried by that conductor. However, extending one of these conductors to cover the entire width of a microbump array may undesirably result in a loss in power efficiency. It would therefore be advantageous to provide alternate means of power delivery for microbumps in the center of the microbump arrays of regions 203 and 207.

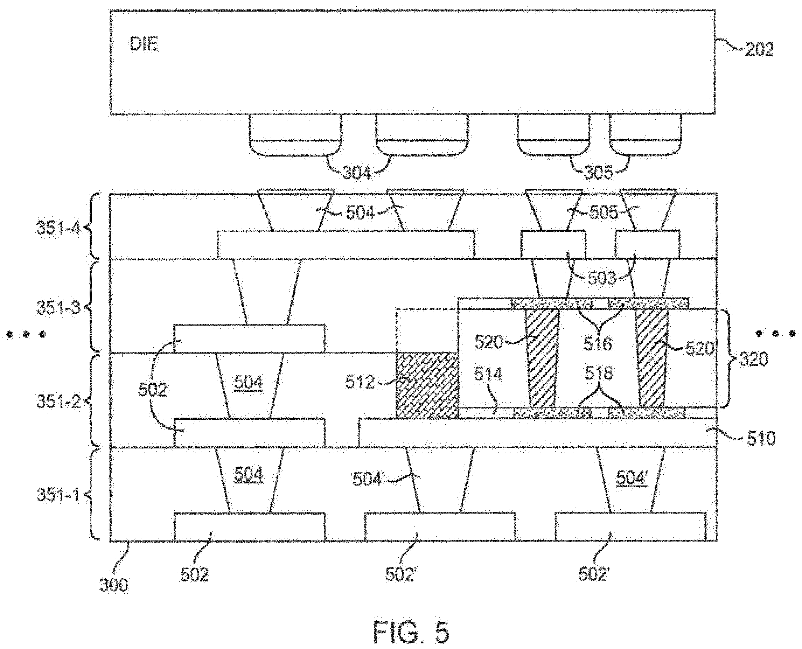

One alternative to the topside microbump power delivery described above is to deliver power and ground signals to the microbumps from the PCB vertically through the package substrate and the EMIB from the back side. As shown in FIG. 5, main die 202 may be mounted onto package substrate 300 using solder bumps (e.g., controlled collapse chip connection (C4) bumps) 304 and microbumps 305. It should be noted that the pitch width of solder bumps 304 may be greater than the pitch width of microbumps 305, such that microbumps 305 have greater connection density than solder bumps 304. The diameter of microbumps 305 are also generally smaller than the diameter of C4 bumps 304 (e.g., bumps 305 may be at least two times smaller, at least four times smaller, etc.)

Solder bumps 304 may be provided with signals (e.g., data signals or power supply voltage signals) from a printed circuit board (e.g., PCB 350 of FIG. 3) through vias 504 and traces 502 formed in routing layers 351-1, 351-2, 351-3, and 351-4 of package substrate 300. If desired, the package substrate may include additional layers (e.g., the number of layers in the package substrate is not limited to four).

Microbumps 305 may be provided with signals (e.g, data signals or power supply voltage signals) from EMIB 320 through vias 505 and traces 503. The signals provided to microbumps 305 may be received from another chip coupled to EMIB 302 or from a PCB (e.g., PCB 350 of FIG. 3) on which package substrate 300 is mounted. It should be noted that vias 505 may be smaller than vias 504 and vias 504'.

According to the claimed invention, EMIB 320 may be mounted on a back side conductor (e.g., conductive layer or copper conductive layer) 510 in layer 351-2 of package substrate 300 using an adhesive layer 514 during fabrication of package substrate 300. A cavity 512 may be included adjacent to EMIB 320 in order to account for differences between the coefficient of thermal expansion between EMIB 320 and package substrate 300, which may reduce thermal stresses placed on EMIB 320.

EMIB 320 may include through-silicon vias (TSVs) that extend vertically from the front side of EMIB 320 to the back side of EMIB 320 to connect contact pads 516 formed on the front side of EMIB 320 to contact pads 518 formed on the back side of EMIB 320. Adhesive layer 514 may be patterned to accommodate contact pads 518 to ensure that contact pads 518 are in electrical contact with back side conductor 510. In other words, adhesive layer 514 may laterally surround contact pads 518 of EMIB 320 without being interposed between contact pads 518 and back side conductor 510.

In accordance with an embodiment, back side conductor 510 may receive power supply voltage signals and/or data signals from a PCB (e.g., PCB 350 of FIG. 3) through vias 504' and traces 502' and may provide these signals to contact pads 518 of EMIB 320. It should be noted that vias 504' may have a diameter that is larger than the diameter of vias 505. Having a larger diameter allows vias 504' to carry more power than would be achievable with vias having a comparatively smaller diameter.

By providing signals to EMIB 320 from the PCB through back side conductor 510, vias 504', and traces 502', and providing power to one or both circuit dies through TSVs 520 in EMIB 320, vertical power distribution may be achieved through EMIB 320.

Conventional EMIB arrangements lack such back side vertical power distribution paths and instead are limited to passing power between chips connected by the EMIB over the EMIB itself or by routing power to these chips around the EMIB. Both of these conventional power distribution options disadvantageously reduce power efficiency of the system containing the EMIB by requiring smaller gauge traces or longer traces for power delivery compared to the vertical power distribution path coupled to EMIB 320.

Thus, the vertical power distribution path coupled between the PCB and the back side of EMIB 320 that includes back side conductor 510, vias 504', and traces 502' is advantageous over these conventional EMIB arrangements in terms of power efficiency.

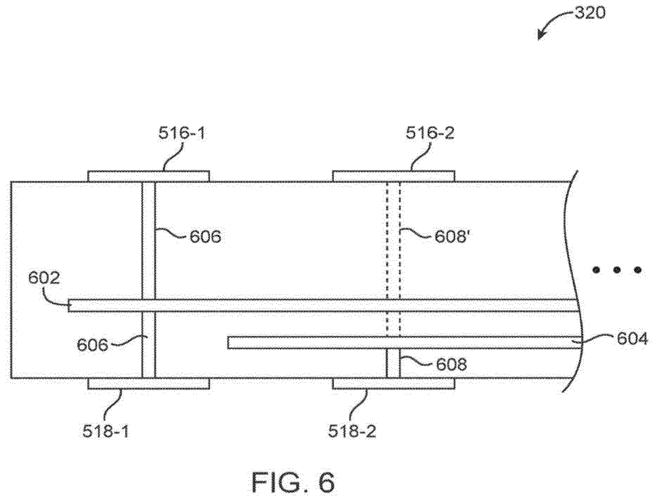

Signals may also be provided from the PCB to internal interconnects of EMIB 320. As shown in FIG. 6, EMIB 320 may include interconnects (e.g., conductive routing traces) 602 and 604. Contact pads 518-1 and 518-2 may receive power supply voltage signals, ground voltage signals, or data signals (e.g., from back side conductor 510 of FIG. 5), and may pass these signals to EMIB microvias 606 and 608. Microvia 606 may include a portion interposed between interconnect 602 and contact pad 518-1, such that signals received by contact pad 518-1 may be passed to interconnect 602. Microvia 606 may also include a portion interposed between interconnect 602 and contact pad 516-1, such that signals received by contact pad 518-1 may also be passed to contact pad 516-1 and thereby to any microbumps coupled to contact pad 516-1.

Microvia 608 may only extend from contact pad 518-2 to interconnect 604. Contact pad 518-2 may pass received signals to interconnect 604 through microvia 608. Optionally, an additional microvia 608' may be interposed between interconnect 602 and interconnect 604 and/or may be interposed between contact pad 516-2 and interconnect 602. This arrangement allows for signals received by contact pad 518-2 to be passed to each of interconnects 602 and 604 and to contact pad 516-2 and thereby to any microbumps coupled to contact pad 516-2.

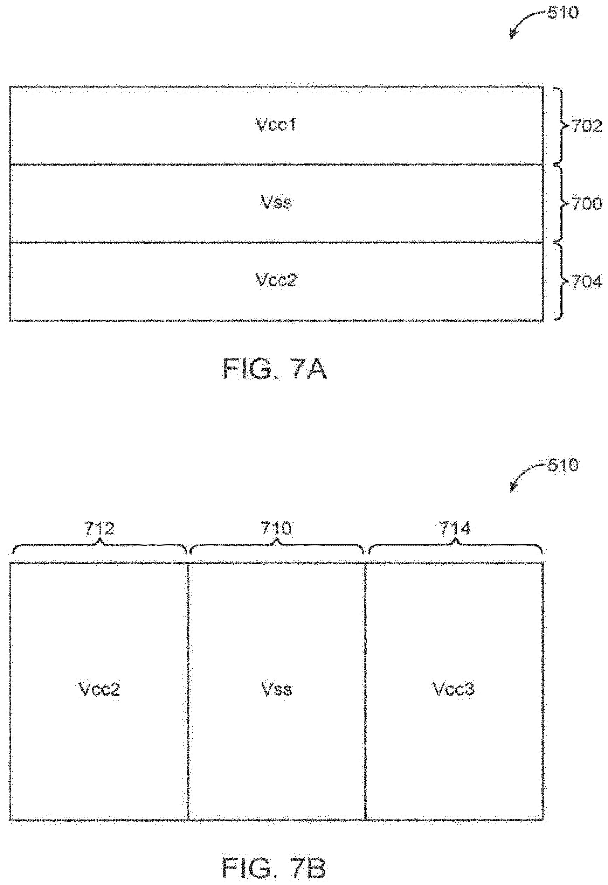

If desired, back side conductor 510 of FIG. 5 may be separated into multiple regions that are electrically isolated from one another, where each region may receive a different power supply voltage signal, ground voltage signal, or data signal from the PCB. Some possible arrangements of back side conductor 510 are described below in connection with FIGS. 7A-7C.

As shown in FIG. 7A, back side conductor 510 may be horizontally separated into regions 700, 702, and 704 that are each electrically isolated from one another. Power supply voltage signal Vcc1 may be applied to region 702. Common (e.g., ground) power supply voltage signal Vss may be applied to region 700. Power supply voltage signal Vcc2 may be applied to region 704. This arrangement of back side conductor 510 allows for the three different types of power/ground voltage signals to be applied to the microbumps of either of the two chips connected to one another through the EMIB (e.g., EMIB 320) attached to back side conductor 510.

As shown in FIG. 7B, back side conductor 510 may be vertically separated into regions 710, 712, and 714 that are each electrically isolated from one another. Power supply voltage signal Vcc2 may be applied to region 712. Common (e.g., ground) power supply voltage signal Vss may be applied to region 710. Power supply voltage signal Vcc3 may be applied to region 714. This arrangement of back side conductor 510 allows for power supply voltage signal Vcc2 to be applied to the microbumps of one of the two chips connected to one another through the EMIB (e.g., EMIB 320) attached to back side conductor 510, for power supply voltage signal Vcc3 to be applied to the microbumps of the other chip of the two chips, and for common signal Vss to be applied to either or both of the two chips.

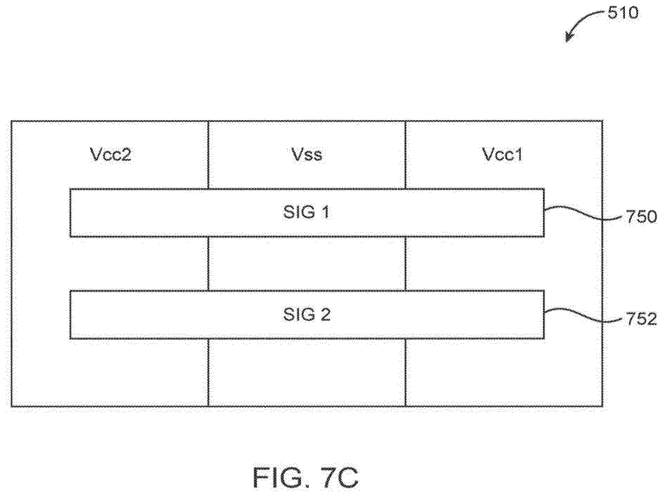

As shown in FIG. 7C, back side conductor 510 may be separated into three vertically separated regions that are each electrically isolated from one another, similar to the arrangement of FIG. 7B. Each vertically separated region may receive one of power supply voltage signal Vcc1, power supply voltage signal Vcc2, and common signal Vss. Back side conductor 510 may further include two horizontal regions 750 and 752 that are electrically isolated from one another and from the three separated vertical regions. Data signal SIG1 may be applied to region 750 and data signal SIG 2 may be applied to region 752. In this way, data signals may also be passed to the EMIB (e.g., EMIB 320) that is mounted on back side conductor 510.

The arrangements of back side conductor 510 shown in FIGS. 7A-C are merely illustrative. If desired, back side conductor 510 may include any number of regions that are electrically isolated from one another and that each receive a different power supply voltage signal or data signal (e.g., from a printed circuit board).

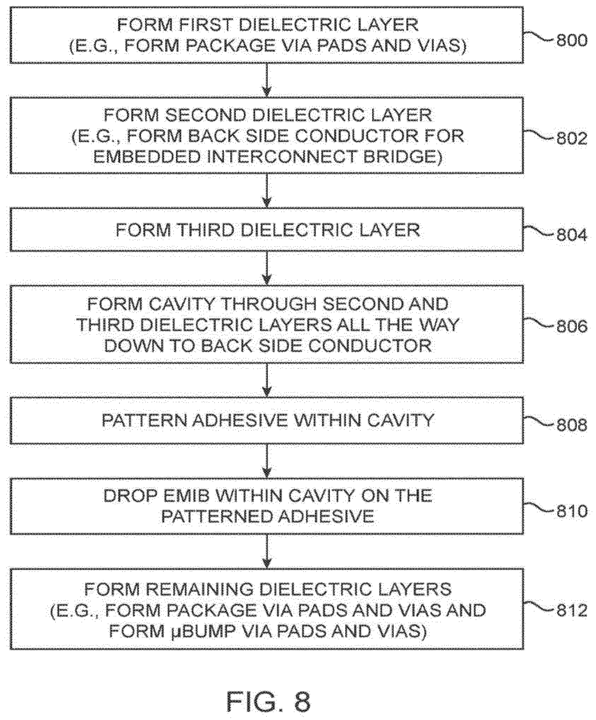

FIG. 8 shows the illustrative steps performed when manufacturing package substrate 300 of FIG. 5.

At step 800, first dielectric layer 351-1 may be formed. Vias 504 and 504' in layer 351-1 and traces 502 and 502' may also be formed at this step.

At step 802, second dielectric layer 351-2 may be formed. Via 504, trace 502, and back side conductor 510 may also be formed in layer 351-2 at this step. As described in connection with FIGS. 7A-7C above, back side conductor 510 may be formed having multiple regions that are electrically isolated from one another and that each receive a different power supply voltage signal or data signal.

At step 804, third dielectric layer 351-3 may be formed. Via 504 and trace 502 may be formed in layer 351-3 at this step.

At step 806, A cavity may be formed in second dielectric layer 351-2 and third dielectric layer 351-3 (e.g., using photolithographic etching, lapping, or drilling). The cavity may overlap back side conductor 510 and may extend through layers 351-2 and 351-3 so as to expose back side conductor 510.

At step 808, adhesive layer 514 may be patterned within the cavity, such that openings are formed in adhesive layer 514 to accommodate contact pads 518 of EMIB 320.

At step 810, EMIB 320 may be placed on the patterned adhesive within the cavity, and may thereby be mounted on back side conductor 510. It should be noted that any TSVs or internal EMIB microvias may already be formed within EMIB 320 prior to the placement of EMIB 320 in the cavity (e.g., during fabrication of EMIB 320).

At step 812, remaining dielectric layers including dielectric layer 851-4 and the portion of dielectric layer 851-3 disposed over EMIB 320 may be formed. Vias 504 and 505 and traces (e.g., via pads) 502 and 503 may also be formed at this step.

Optionally, step 804 may be omitted and the entirety of layer 851-3 may be formed during step 812. In this optional case, the cavity only needs to be formed in second dielectric layer 851-2 during step 806.

The embodiments thus far have been described with respect to integrated circuits. The methods and apparatuses described herein may be incorporated into any suitable circuit. For example, they may be incorporated into numerous types of devices such as programmable logic devices, application specific standard products (ASSPs), and application specific integrated circuits (ASICs). Examples of programmable logic devices include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The foregoing is merely illustrative of the principles of this invention and various modifications can be made by those skilled in the art.

## Claims

1. A multi-chip package, comprising:
an interconnect bridge (320) having a first contact pad (516) and a second contact pad (516) thereon, the interconnect bridge (320) comprising a silicon die (202), wherein the interconnect bridge (320) is mounted on a conductive layer (510);
a first dielectric layer (351-2), the first dielectric layer (351-2) laterally adjacent the interconnect bridge (320), and the first dielectric layer (351-2) laterally adjacent and in contact with the conductive layer (510);
a second dielectric layer (351-3) on the first dielectric layer (351-2) and on the interconnect bridge (320), the second dielectric layer (351-3) over the conductive layer (510);
a first via in the second dielectric layer (351-3), the first via coupled to the first contact pad (516);
a second via in the second dielectric layer (351-3), the second via coupled to the second contact pad (516);
a third via in the second dielectric layer (351-3), the third via coupled to a via (504) in the first dielectric layer (351-2);
a third dielectric layer (351-4) on the second dielectric layer (351-3), the third dielectric layer (351-4) over the interconnect bridge (320) and over the conductive layer (510);
a first conductive trace (503) in the third dielectric layer (351-4), the first conductive trace coupled to the first via;
a second conductive trace (503) in the third dielectric layer (351-4), the second conductive trace coupled to the second via;
a third conductive trace in the third dielectric layer (351-4), the third conductive trace coupled to the third via;
a first die (202) over the third dielectric layer (351-4), the first die (202) over the interconnect bridge (320) and over the conductive layer (510), and the first die (202) coupled to the first conductive trace and to the second conductive trace; and
a second die (205) over the interconnect bridge (320), the second die (205) coupled to the first die (202) by the interconnect bridge (320).

2. The multi-chip package of claim 1, wherein the first conductive trace is not coupled to the second conductive trace.

3. The multi-chip package of any one of claims 1-2, further comprising:
a cavity laterally between the interconnect bridge (320) and the first dielectric layer (351-2).

4. The multi-chip package of any one of claims 1-3, wherein the interconnect bridge (320) is laterally spaced apart from the first dielectric layer (351-2).

5. The multi-chip package of any one of claims 1-4, wherein the first die (202) is a main die, and the second die (205) is a secondary die.

6. The multi-chip package of claim 5, wherein the main die (202) is a die (202) selected from the group consisting of a central processing unit (CPU) die, a graphics processing unit (GPU) die, and an application-specific integrated circuit (ASIC) die, and wherein the secondary die (202) is a die (202) selected from the group consisting of a memory die (202) and a transceiver die.

7. The multi-chip package of any one of claims 1-6, wherein the first die (202) is coupled to the interconnect bridge (320) by a first plurality of conductive bumps having a first pitch, and wherein the first die (202) further comprises a second plurality of conductive bumps having a second pitch greater than the first pitch.

8. The multi-chip package of claim 7, wherein the second die (205) is coupled to the interconnect bridge (320) by a third plurality of conductive bumps having a third pitch, and wherein the second die (205) further comprises a fourth plurality of conductive bumps having a fourth pitch greater than the third pitch.

9. A system, comprising:
a printed circuit board (350);
a package substrate (300) coupled to a printed circuit board (350);
a first die (202) coupled to the package substrate (300); and
a second die (205) coupled to the package substrate (300), wherein the package substrate (300) comprises:
an interconnect bridge (320) having a first contact pad (516) and a second contact pad (516) thereon, the interconnect bridge (320) comprising a silicon die, wherein the interconnect bridge (320) is mounted on a conductive layer (510);
a first dielectric layer (351-2), the first dielectric layer (351-2) laterally adjacent the interconnect bridge (320), and the first dielectric layer (351-2) laterally adjacent and in contact with the conductive layer (510);
a second dielectric layer (351-3) on the first dielectric layer (351-2) and on the interconnect bridge (320), the second dielectric layer (351-3) over the conductive layer (510);
a first via in the second dielectric layer (351-3), the first via coupled to the first contact pad (516);
a second via in the second dielectric layer (351-3), the second via coupled to the second contact pad (516);
a third via in the second dielectric layer (351-3), the third via coupled to a via (504) in the first dielectric layer (351-2);
a third dielectric layer (351-4) on the second dielectric layer (351-3), the third dielectric layer (351-4) over the interconnect bridge (320) and over the conductive layer (510);
a first conductive trace (503) in the third dielectric layer (351-4), the first conductive trace coupled to the first via;
a second conductive trace (503) in the third dielectric layer (351-4), the second conductive trace coupled to the second via;
a third conductive trace in the third dielectric layer (351-4), the third conductive trace coupled to the third via;
wherein the first die (202) is over the third dielectric layer (351-4), and the first die (202) is over the interconnect bridge (320) and over the conductive layer (510), the first die (202) coupled to the first conductive trace and to the second conductive trace; and
wherein the second die (205) is over the interconnect bridge (320), the second die (205) coupled to the first die (202) by the interconnect bridge (320).

10. The system of claim 9, wherein the package substrate (300) is coupled to the printed circuit board (350) by a plurality of solder balls.

11. The system of claim 10, wherein a first of the plurality of solder balls is vertically beneath the interconnect bridge (320), and wherein a second of the plurality of solder balls is vertically beneath the conductive layer (510).

12. The system of any one of claims 9-11, wherein the package substrate (300) is coupled to the printed circuit board (350) by a plurality of solder bumps.

13. The system of claim 12, wherein a first of the plurality of solder bumps is vertically beneath the interconnect bridge (320), and wherein a second of the plurality of solder bumps is vertically beneath the conductive layer (510).

14. The system of any one of claims 9-13, wherein the first conductive trace is not coupled to the second conductive trace.

15. The system of any one of claims 9-14, further comprising:
a cavity laterally between the interconnect bridge (320) and the first dielectric layer (351-2).

## Patentansprüche

1. Multi-Chip-Baugruppe, die Folgendes umfasst:
eine Verbindungsbrücke (320) mit einer ersten Kontaktfläche (516) und einer zweiten Kontaktfläche (516) darauf, wobei die Verbindungsbrücke (320) einen Silizium-Chip (202) umfasst, wobei die Verbindungsbrücke (320) auf einer leitenden Schicht (510) angebracht ist;
eine erste dielektrische Schicht (351-2), wobei die erste dielektrische Schicht (351-2) seitlich an die Verbindungsbrücke (320) angrenzt und die erste dielektrische Schicht (351-2) seitlich an die leitende Schicht (510) angrenzt und mit ihr in Kontakt ist;
eine zweite dielektrische Schicht (351-3) auf der ersten dielektrischen Schicht (351-2) und auf der Verbindungsbrücke (320), wobei sich die zweite dielektrische Schicht (351-3) über der leitenden Schicht (510) befindet;
ein erstes Kontaktloch in der zweiten dielektrischen Schicht (351-3), wobei das erste Kontaktloch an die erste Kontaktfläche (516) gekoppelt ist;
ein zweites Kontaktloch in der zweiten dielektrischen Schicht (351-3), wobei das zweite Kontaktloch an die zweite Kontaktfläche (516) gekoppelt ist;
ein drittes Kontaktloch in der zweiten dielektrischen Schicht (351-3), wobei das dritte Kontaktloch an ein Kontaktloch (504) in der ersten dielektrischen Schicht (351-2)gekoppelt ist;
eine dritte dielektrische Schicht (351-4) auf der zweiten dielektrischen Schicht (351-3), wobei sich die dritte dielektrische Schicht (351-4) über der Verbindungsbrücke (320) und über der leitenden Schicht (510) befindet;
eine erste leitende Spur (503) in der dritten dielektrischen Schicht (351-4), wobei die erste leitende Spur an das erste Kontaktloch gekoppelt ist;
eine zweite leitende Spur (503) in der dritten dielektrischen Schicht (351-4), wobei die zweite leitende Spur an das zweite Kontaktloch gekoppelt ist;
eine dritte leitende Spur in der dritten dielektrischen Schicht (351-4), wobei die dritte leitende Spur an das dritte Kontaktloch gekoppelt ist;
einen ersten Chip (202) über der dritten dielektrischen Schicht (351-4), wobei sich der erste Chip (202) über der Verbindungsbrücke (320) und über der leitenden Schicht (510) befindet und der erste Chip (202) an die erste leitende Spur und die zweite leitende Spur gekoppelt ist; und
einen zweiten Chip (205) über der Verbindungsbrücke (320), wobei der zweite Chip (205) durch die Verbindungsbrücke (320) an den ersten Chip (202) gekoppelt ist.

2. Multi-Chip-Baugruppe nach Anspruch 1, wobei die erste leitende Spur nicht an die zweite leitende Spur gekoppelt ist.

3. Multi-Chip-Baugruppe nach einem der Ansprüche 1-2, das ferner Folgendes umfasst:
einen Hohlraum, der sich seitlich zwischen der Verbindungsbrücke (320) und der ersten dielektrischen Schicht (351-2) befindet.

4. Multi-Chip-Baugruppe nach einem der Ansprüche 1-3, wobei die Verbindungsbrücke (320) von der ersten dielektrischen Schicht (351-2) seitlich beabstandet ist.

5. Multi-Chip-Baugruppe nach einem der Ansprüche 1-4, wobei der erste Chip (202) ein Haupt-Chip ist und der zweite Chip (205) ein sekundärer Chip ist.

6. Multi-Chip-Baugruppe nach Anspruch 5, wobei der Haupt-Chip (202) ein Chip (202) ist, der aus der Gruppe gewählt ist, die aus einem Chip einer Zentraleinheit (CPU), einem Chip einer Grafikverarbeitungseinheit (GPU) und einem Chip einer anwendungsspezifischen integrierten Schaltung (ASIC) besteht, und wobei der sekundäre Chip (202) ein Chip (202) ist, der aus der Gruppe gewählt ist, die aus einem Speicher-Chip (202) und einem Sendeempfänger-Chip besteht.

7. Multi-Chip-Baugruppe nach einem der Ansprüche 1-6, wobei der erste Chip (202) durch mehrere erste leitende Erhebungen mit einem ersten Abstand an die Verbindungsbrücke (320) gekoppelt ist und wobei der erste Chip (202) ferner mehrere zweite leitende Erhebungen mit einem zweiten Abstand, der größer als der ersten Abstand ist, umfasst.

8. Multi-Chip-Baugruppe nach Anspruch 7, wobei der zweite Chip (205) durch mehrere dritte leitende Erhebungen mit einem dritten Abstand an die Verbindungsbrücke (320) gekoppelt ist und wobei der zweite Chip (205) ferner mehrere vierte leitende Erhebungen mit einem vierten Abstand, der größer als der dritte Abstand ist, umfasst.

9. System, das Folgendes umfasst:
ein gedruckte Leiterplatte (350);
ein Baugruppensubstrat (300), das an eine gedruckte Leiterplatte (350) gekoppelt ist;
einen ersten Chip (202), der an das Baugruppensubstrat (300) gekoppelt ist; und
einen zweiten Chip (205), der an das Baugruppensubstrat (300) gekoppelt ist, wobei das Baugruppensubstrat (300) Folgendes umfasst:
eine Verbindungsbrücke (320) mit einer ersten Kontaktfläche (516) und einer zweiten Kontaktfläche (516) darauf, wobei die Verbindungsbrücke (320) einen Silizium-Chip umfasst, wobei die Verbindungsbrücke (320) auf einer leitenden Schicht (510) angebracht ist;
eine erste dielektrische Schicht (351-2), wobei die erste dielektrische Schicht (351-2) seitlich an die Verbindungsbrücke (320) angrenzt und die erste dielektrische Schicht (351-2) seitlich an die leitende Schicht (510) angrenzt und mit ihr in Kontakt ist;
eine zweite dielektrische Schicht (351-3) auf der ersten dielektrischen Schicht (351-2) und auf der Verbindungsbrücke (320), wobei sich zweite dielektrische Schicht (351-3) über der leitenden Schicht (510) befindet;
ein erstes Kontaktloch in der zweiten dielektrischen Schicht (351-3), wobei das erste Kontaktloch an die erste Kontaktfläche (516) gekoppelt ist;
ein zweites Kontaktloch in der zweiten dielektrischen Schicht (351-3), wobei das zweite Kontaktloch an die zweite Kontaktfläche (516) gekoppelt ist;
ein drittes Kontaktloch in der zweiten dielektrischen Schicht (351-3), wobei das dritte Kontaktloch an ein Kontaktloch (504) in der ersten dielektrischen Schicht (351-2) gekoppelt ist;
eine dritte dielektrische Schicht (351-4) auf der zweiten dielektrischen Schicht (351-3), wobei sich die dritte dielektrische Schicht (351-4) über der Verbindungsbrücke (320) und über der leitenden Schicht (510) befindet;
eine erste leitende Spur (503) in der dritten dielektrischen Schicht (351-4), wobei die erste leitende Spur an das erste Kontaktloch gekoppelt ist;
eine zweite leitende Spur (503) in der dritten dielektrischen Schicht (351-4), wobei die zweite leitende Spur an das zweite Kontaktloch gekoppelt ist;
eine dritte leitende Spur in der dritten dielektrischen Schicht (351-4), wobei die dritte leitende Spur an das dritte Kontaktloch gekoppelt ist;
wobei sich der erste Chip (202) über der dritten dielektrischen Schicht (351-4) befindet, wobei sich der erste Chip (202) über der Verbindungsbrücke (320) und über der leitenden Schicht (510) befindet und wobei der erste Chip (202) an die erste leitende Spur und die zweite leitende Spur gekoppelt ist; und
wobei sich der zweite Chip (205) über der Verbindungsbrücke (320) befindet und wobei der zweite Chip (205) durch die Verbindungsbrücke (320) an den ersten Chip (202) gekoppelt ist.

10. System nach Anspruch 9, wobei das Baugruppensubstrat (300) durch mehrere Lötkugeln an die gedruckte Leiterplatte (350) gekoppelt ist.

11. System nach Anspruch 10, wobei eine erste der mehreren Lötkugeln vertikal unter der Verbindungsbrücke (320) ist und wobei eine zweite der mehreren Lötkugeln vertikal unter der leitenden Schicht (510) ist.

12. System nach einem der Ansprüche 9-11, wobei das Baugruppensubstrat (300) durch mehrere Löterhebungen an die gedruckte Leiterplatte (350) gekoppelt ist.

13. System nach Anspruch 12, wobei sich eine erste der mehreren Löterhebungen vertikal unter der Verbindungsbrücke (320) befindet und wobei sich eine zweite der mehreren Löterhebungen vertikal unter der leitenden Schicht (510) befindet.

14. System nach einem der Ansprüche 9-13, wobei die erste leitende Spur nicht an die zweite leitende Spur gekoppelt ist.

15. System nach einem der Ansprüche 9-14, das ferner Folgendes umfasst:
einen Hohlraum, der sich seitlich zwischen der Verbindungsbrücke (320) und der ersten dielektrischen Schicht (351-2) befindet.

## Revendications

1. Boîtier multi-puces, comprenant :
un pont d'interconnexion (320) ayant une première plage de contact (516) et une seconde plage de contact (516) sur celui-ci, le pont d'interconnexion (320) comprenant une matrice de silicium (202), le pont d'interconnexion (320) étant monté sur une couche conductrice (510) ;
une première couche diélectrique (351-2), la première couche diélectrique (351-2) étant latéralement adjacente au pont d'interconnexion (320), et la première couche diélectrique (351-2) étant latéralement adjacente et en contact avec la couche conductrice (510) ;
une deuxième couche diélectrique (351-3) sur la première couche diélectrique (351-2) et sur le pont d'interconnexion (320), la deuxième couche diélectrique (351-3) étant au-dessus de la couche conductrice (510) ;
un premier trou d'interconnexion dans la deuxième couche diélectrique (351-3), le premier trou d'interconnexion étant couplé à la première plage de contact (516) ;
un deuxième trou d'interconnexion dans la deuxième couche diélectrique (351-3), le deuxième trou d'interconnexion étant couplé à la seconde plage de contact (516) ;
un troisième trou d'interconnexion dans la deuxième couche diélectrique (351-3), le troisième trou d'interconnexion étant couplé à un trou d'interconnexion (504) dans la première couche diélectrique (351-2) ;
une troisième couche diélectrique (351-4) sur la deuxième couche diélectrique (351-3), la troisième couche diélectrique (351-4) étant au-dessus du pont d'interconnexion (320) et au-dessus de la couche conductrice (510) ;
une première trace conductrice (503) dans la troisième couche diélectrique (351-4), la première trace conductrice étant couplée au premier trou d'interconnexion ;
une deuxième trace conductrice (503) dans la troisième couche diélectrique (351-4), la deuxième trace conductrice étant couplée au deuxième trou d'interconnexion ;
une troisième trace conductrice dans la troisième couche diélectrique (351-4), la troisième trace conductrice étant couplée au troisième trou d'interconnexion ;
une première matrice (202) au-dessus de la troisième couche diélectrique (351-4), la première matrice (202) étant au-dessus du pont d'interconnexion (320) et au-dessus de la couche conductrice (510), et la première matrice (202) étant couplée à la première trace conductrice et à la deuxième trace conductrice ; et
une seconde matrice (205) au-dessus du pont d'interconnexion (320), la seconde matrice (205) étant couplée à la première matrice (202) par le pont d'interconnexion (320).

2. Boîtier multi-puces selon la revendication 1, la première trace conductrice n'étant pas couplée à la deuxième trace conductrice.

3. Boîtier multi-puces selon l'une quelconque des revendications 1 et 2, comprenant en outre :
une cavité située latéralement entre le pont d'interconnexion (320) et la première couche diélectrique (351-2).

4. Boîtier multi-puces selon l'une quelconque des revendications 1 à 3, le pont d'interconnexion (320) étant espacé latéralement de la première couche diélectrique (351-2).

5. Boîtier multi-puces selon l'une quelconque des revendications 1 à 4, la première matrice (202) étant une matrice principale, et la seconde matrice (205) étant une matrice secondaire.

6. Boîtier multi-puces selon la revendication 5, la matrice principale (202) étant une matrice (202) sélectionnée dans le groupe constitué d'une matrice d'unité centrale de traitement (CPU), d'une matrice d'unité de traitement graphique (GPU), et d'une matrice de circuit intégré spécifique à une application (ASIC), et la matrice secondaire (202) étant une matrice (202) sélectionnée dans le groupe constitué d'une matrice de mémoire (202) et d'une matrice d'émetteur-récepteur.

7. Boîtier multi-puces selon l'une quelconque des revendications 1 à 6, la première matrice (202) étant couplée au pont d'interconnexion (320) par une première pluralité de bosses conductrices ayant un premier pas, et
la première matrice (202) comprenant en outre une deuxième pluralité de bosses conductrices ayant un deuxième pas supérieur au premier pas.

8. Boîtier multi-puces selon la revendication 7, la seconde matrice (205) étant couplée au pont d'interconnexion (320) par une troisième pluralité de bosses conductrices ayant un troisième pas, et
la seconde matrice (205) comprenant en outre une quatrième pluralité de bosses conductrices ayant un quatrième pas supérieur au troisième pas.

9. Système, comprenant :
une carte de circuit imprimé (350) ;
un substrat de boîtier (300) couplé à une carte de circuit imprimé (350) ;
une première matrice (202) couplée au substrat de boîtier (300) ; et
une seconde matrice (205) couplée au substrat de boîtier (300), le substrat de boîtier (300) comprenant :
un pont d'interconnexion (320) ayant une première plage de contact (516) et une seconde plage de contact (516) sur celui-ci, le pont d'interconnexion (320) comprenant une matrice de silicium, le pont d'interconnexion (320) étant monté sur une couche conductrice (510) ;
une première couche diélectrique (351-2), la première couche diélectrique (351-2) étant latéralement adjacente au pont d'interconnexion (320), et la première couche diélectrique (351-2) étant latéralement adjacente et en contact avec la couche conductrice (510) ;
une deuxième couche diélectrique (351-3) sur la première couche diélectrique (351-2) et sur le pont d'interconnexion (320), la deuxième couche diélectrique (351-3) étant au-dessus de la couche conductrice (510) ;
un premier trou d'interconnexion dans la deuxième couche diélectrique (351-3), le premier trou d'interconnexion étant couplé à la première plage de contact (516) ;
un deuxième trou d'interconnexion dans la deuxième couche diélectrique (351-3), le deuxième trou d'interconnexion étant couplé à la seconde plage de contact (516) ;
un troisième trou d'interconnexion dans la deuxième couche diélectrique (351-3), le troisième trou d'interconnexion étant couplé à un trou d'interconnexion (504) dans la première couche diélectrique (351-2) ;
une troisième couche diélectrique (351-4) sur la deuxième couche diélectrique (351-3), la troisième couche diélectrique (351-4) étant au-dessus du pont d'interconnexion (320) et au-dessus de la couche conductrice (510) ;
une première trace conductrice (503) dans la troisième couche diélectrique (351-4), la première trace conductrice étant couplée au premier trou d'interconnexion ;
une deuxième trace conductrice (503) dans la troisième couche diélectrique (351-4), la deuxième trace conductrice étant couplée au deuxième trou d'interconnexion ;
une troisième trace conductrice dans la troisième couche diélectrique (351-4), la troisième trace conductrice étant couplée au troisième trou d'interconnexion ;
la première matrice (202) étant au-dessus de la troisième couche diélectrique (351-4), et la première matrice (202) étant au-dessus du pont d'interconnexion (320) et au-dessus de la couche conductrice (510), la première matrice (202) étant couplée à la première trace conductrice et à la deuxième trace conductrice ; et
la seconde matrice (205) étant au-dessus du pont d'interconnexion (320), la seconde matrice (205) étant couplée à la première matrice (202) par le pont d'interconnexion (320).

10. Système selon la revendication 9, le substrat de boîtier (300) étant couplé à la carte de circuit imprimé (350) par une pluralité de billes de soudure.

11. Système selon la revendication 10, une première de la pluralité de billes de soudure étant verticalement sous le pont d'interconnexion (320), et une deuxième de la pluralité de billes de soudure étant verticalement sous la couche conductrice (510).

12. Système selon l'une quelconque des revendications 9 à 11, le substrat de boîtier (300) étant couplé à la carte de circuit imprimé (350) par une pluralité de bosses de soudure.

13. Système selon la revendication 12, une première de la pluralité de bosses de soudure étant verticalement sous le pont d'interconnexion (320), et une deuxième de la pluralité de bosses de soudure étant verticalement sous la couche conductrice (510).

14. Système selon l'une quelconque des revendications 9 à 13, la première trace conductrice n'étant pas couplée à la deuxième trace conductrice.

15. Système selon l'une quelconque des revendications 9 à 14, comprenant en outre :
une cavité située latéralement entre le pont d'interconnexion (320) et la première couche diélectrique (351-2).
